# EUROPEAN PATENT APPLICATION

(11) **EP 2 866 314 A1**
(43) Date of publication of application: **29.04.2015**
(21) Application number: 13005072.7
(22) Date of filing: 24.10.2013
(51) Int. Cl.: H01S 5/068, H01S 5/10, H01S 5/12, H01S 5/34

(54) **Method and device for frequency control and stabilization of a semiconductor laser**

(71) Applicant: ETH Zurich, 8092 Zurich (CH)
(72) Inventor: Faist, Jérôme, 8052 Zürich (CH); Hugi, Andreas, CH - 8048 Zürich (CH); Villares, Gustavo, CH - 8057 Zürich (CH)

(57) **Abstract**

The present invention relates to a method for stabilizing and/or controlling an optical frequency of a multi-mode laser output (2) of a semiconductor laser device, wherein an optical beating frequency of said laser output (2) is within a bandwidth of a gain-recovery process dominating said semiconductor laser device (3). The method includes the steps of producing the laser output (2), wherein the semiconductor laser device (3) includes a control unit (4) for driving and/or stabilization purposes, the control unit (4) including at least one driver set value. The method further includes the steps of detecting electrically, by means of an electrical detection device, in a bias voltage or in a laser driver current of said semiconductor laser device (3), an electrical beating signal that corresponds to said optical beating frequency and of back-feeding the electrical beating signal into an electronic correction loop for correcting said at least one driver set value of the control unit (4) for matching the detected electrical beating signal to a predetermined beating frequency. The invention also relates to a laser device applying said method.

## Description

### TECHNICAL FIELD

The present invention relates to a method for frequency control and/or stabilization of a semiconductor laser according to the preamble of claim 1 and to laser devices stabilized by said method.

### PRIOR ART

Laser light signals are the cornerstone for a plethora of technical applications, including imaging, spectroscopy, or communication technology.

Laser light is typically produced in an active zone of a laser cavity with a pumped gain medium. Important parameters, such as lasing frequency or the spectral profile of the laser light output, are directly linked to the actual geometry of the laser cavity. Variations in environmental conditions, like e.g. temperature, cause said geometry to change in time, which entails fluctuations in the laser light signals.

Most of the aforementioned applications gain from or even depend on proper frequency control and stability of the optical signals. Hence, active frequency stabilizing techniques are at present implemented into laser devices. Current approaches involve the optical detection of part of the very signals to be stabilized for stabilizing purposes and rely on back-feeding the detected laser light signals into the stabilization process.

The stabilization and control of the laser output frequency is at least therefore of great importance for many applications relying on a stable and controllable output frequency/wavelength. In telecommunication applications, for example, a wavelength-division multiplexed system relies on a stable output wavelength. In sensing applications, the stabilization and control of the output wavelength is important to scan with high precision through an absorption line. A sensing system employing an ultra-stable oscillator, which is tuned to an absorption line, would greatly profit in accuracy due to the reduced variations in frequency/wavelength, since the variations in frequency directly translates into a variation in measured intensity.

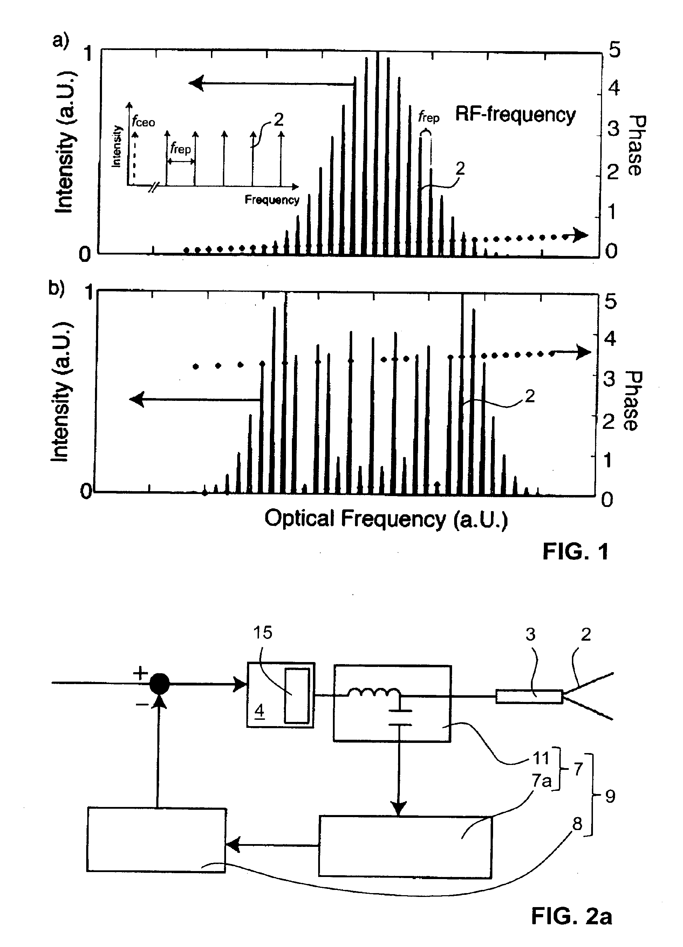

A particular example in which the stabilization of the wavelength is very important is an optical frequency comb. Optical frequency combs are defmed by their exact spacing of the comb modes. It is at the same time a broadband and a coherent spectrum. Each comb tooth frequency can be described as *f* = *f*_{ceo} + n × *f*ᵣₑₚ (*cf.* Fig. 1; n being an integer). Therefore, they act as a ruler in the optical frequency domain and are used as a direct optical to RF-frequency link. This direct link is of paramount importance for optical frequency comb measurement techniques. A fully stabilized comb in the optical domain will result in an ultra-stable local oscillator in the RF-domain. Optical frequency combs have revolutionized many fields, including fundamental time metrology, spectroscopy and frequency synthesis.

For most applications, it is advantageous or even required to fully stabilize the optical frequency comb. Fully stabilizing means: fixing at the same time *f*_{ceo} and *f*ᵣₑₚ, resulting in a laser spectrum in which every single tooth is fixed to a certain wavelength. Therefore, to fully stabilize a comb, both parameters *f*_{ceo} and *f*ᵣₑₚ needs to be stabilized. Passive stabilization of *f*ᵣₑₚ is often achieved through a nonlinear interaction in the laser cavity. Active stabilization of *f*ᵣₑₚ by means of an amplitude or phase modulator can also be done. However to fully stabilize the comb, it is still necessary to stabilize *f*_{ceo} by stabilizing the output wavelength of one laser line.

There are numerous possible ways to stabilize the output wavelength of a laser. Often they rely on a feedback mechanism of an error signal. Usually, the error signal is fed into a phase-locked loop or is digitally analyzed to gain more freedom to react to the system (*cf*. US 6,839,363 B2). The error signal acts on the effective laser cavity length to counteract the drift of the wavelength.

Prior art analyzes the optical output of a laser device to generate said error signal. The external reference can be for example a molecular absorption line, a resonance induced by the optogalvanic effect, a high-fmesse Fabry-Pérot cavity, a stable local oscillator in the RF-domain, or another stable laser source.

A few examples illustrating the state of the art follow. A method to stabilize a single mode laser for example described in DE 19 633 569 A1, comparing the transmitted power of a single-mode laser through two different Bragg-Gratings.

According to the teaching of EP 1 372 275 A1 a tunable oscillator is locked to an optical reference signal generating a beating frequency in the RF domain, which can be used to stabilize the actual frequency to the optical frequency. In principle, all locking-mechanisms used to stabilize the wavelength of single mode laser can be used to stabilize *f*_{ceo} in optical frequency combs. It is enough to extract one comb tooth by a dispersive method and stabilize said tooth of the comb to an external reference as described before.

However, it is also possible to self-reference an octave spanning comb. A common way to stabilize *f*_{ceo} without the use of any external reference can be achieved through *f*-to-2*f* stabilization techniques, which requires an octave-spanning comb (*cf.* US 6,850,543 B2). The stabilization depends on generating an optical beat-frequency on a detector. The beating is generated by a frequency doubled separated first frequency output and a second frequency of twice the first frequency. Due to the importance to stabilize an optical comb output, there are numerous applications describing the possible phase stabilization of said laser sources (*cf*. US 4,685,111, US 5,646,774, US 7,079,558, US 7,881,620, US 4,025,875, WO 0221649, WO 2010 063051, WO 2009 000079, WO 9419847).

There have been several different methods presented to phase lock THZ quantum cascade lasers (QCLs). It was shown, that it is possible to phase-lock to an up converted RF-oscillator. Phase locking of a THZ QCL was also demonstrated through active stabilization to the nth harmonic of a commercial, mode-locked erbium-doped fiber laser as described in WO 2011 124829 A1. Using this technique to fix *f*_{ceo} by phase-locking a single line of a THZ QCL in combination with a RF-injected signal to fix *f*ᵣₑₚ, they are able to fully stabilize a THZ QCL comb.

In all those schemes, the wavelength stabilization relies on the analysis of the output optical signal, since all prior techniques require the measurement and monitor of the laser output or an optical beat signal.

### SUMMARY OF THE INVENTION

It is thus an object of the present invention to provide an improved method for stabilizing multi-mode laser outputs such as optical frequency combs.

This object is achieved by the method according to claim 1. According to this, said object is achieved by a method for stabilizing and/or controlling at least one optical frequency of a multi-mode laser output of a semiconductor laser device, the multi-mode laser output having an optical carrier offset frequency and at least one optical beating frequency, wherein the at least one optical beating frequency of said laser output is within a bandwidth of a gain-recovery process dominating said semiconductor laser device, the method including the steps of:
- producing the laser output by means of said semiconductor laser device, wherein the semiconductor laser device includes a control unit for driving and/or stabilization purposes, the control unit including at least one driver set value;
- detecting electrically, by means of an electrical detection device, in a bias voltage or in a laser driver current of said semiconductor laser device, at least one electrical beating signal that corresponds to such an optical beating frequency of said laser output; and
- back-feeding the electrical beating signal into an electronic correction loop and correcting said at least one driver set value of the control unit for matching the detected electrical beating signal to a predetermined beating frequency.

The invention is based on the insight that the beating signals in the optical fields of a quantum cascade laser with fast enough gain dynamics are transferred to a beating of the electronic population in the active zone of the laser and consequently available electronically for correction or stabilization purposes. Hence, this electric beating signal can be used in any semiconductor laser for correction or stabilization purposes if the frequency of said signal is within the bandwidth of the gain-recovery processes dominating in said laser. A mode-locked semiconductor laser used for multi-mode, in particular for optical frequency comb generation may thus be actively controlled by the herein proposed device for production of an all-electrically stabilized semiconductor laser frequency comb.

It is an aspect of the current invention that no optical detectors must be involved, or in other words the stabilization method and the apparatus according to invention does not rely on any analysis of the optical output signal. It is thus an aspect of the present invention to provide a method and apparatus for fully stabilizing multi-mode semiconductor laser outputs, in particular optical frequency combs using only electrical means.

According to this invention, the semiconductor laser in question, most preferably a quantum cascade laser device, is emitting a multi-mode laser output, preferably a comb of optical frequencies and acts as its own electrical detector. It allows detecting any down mixed signal to the RF-domain originating of multiple laser oscillations without the need of any external optical detector or wavelength-scanning unit. For example, it allows measuring the inter-mode beats and amplitude noise at low frequencies of a QCL comb output.

Preferably, the controlling and stabilization can therefore be realized using only those RF-signals directly accessible on the semiconductor laser.

Preferably, the multi-mode laser output is an optical frequency comb with preferably low group velocity dispersion, preferably comprising a plurality of in a frequency domain equidistantly spaced comb modes.

In case of conventional semiconductor lasers or conventional QCLs, a low group-velocity dispersion (GVD) is to be understood as a positive or negative GVD with an absolute value smaller than or equal to 75 ps²m⁻¹, preferably smaller than or equal to 50 ps²m⁻¹, more preferably smaller than or equal to 10 ps²m⁻¹, and in particular smaller than or equal to about 1 ps²m⁻¹.

The ability to lock longitudinal modes together to generate a frequency comb is generally limited by the material group velocity dispersion. Therefore a low group velocity dispersion in an optical frequency combs is desirable. Lowering the group velocity dispersion is beneficial when increasing the spectral bandwidth of the frequency-comb.

A low GVD in a semiconductor can be accomplished by different means. Among others, some means are the following ones: First, the material dispersion in the desired wavelength range plays a crucial role; therefore the chosen material system for the implementation of the laser should be carefully selected. Second, the doping of the active region and the waveguide influence the GVD. Third, the GVD can be engineered by resonator design. A common approach is for example the incorporation of a double-chirped optical mirror design. And fourth, gain induced dispersion should be addressed. A broadband active region generally features a GVD with a broad minimum in the center of the gain curve, owing to the flat top shape of the gain curve of the broadband laser.

In a particularly preferred embodiment, the semiconductor laser device is or includes a quantum cascade laser device or a dual- or multi-color DFB laser device, or any quantum cascade laser device emitting radiation on a multiple of optical frequencies.

In the case of the QLC comb, locking the inter-mode beat to an external reference effectively results in a stabilization of the entire system, meaning *f*_{ceo} and *f*ᵣₑₚ.

Preferably, noise information on said bias voltage or on said laser driver current in the frequency range from Hz to MHz is determined and compared to a reference in order to determine a locking state of the semiconductor laser device.

According to a preferred embodiment, the electrical detection device includes a bias-tee for extracting the electrical beating signal, which is extracted by means of said bias-tee. Alternatively or additionally, the electrical detection device includes a directional coupler for extracting the electrical beating signal, which is extracted by means of said directional coupler.

Preferably, the optical frequency comb is an octave spanning optical frequency comb, wherein the semiconductor laser device has a second order nonlinearity, preferably engineerable by bandstructure design of the active region as it is the case in a QCL, and wherein, through second-harmonic generation, a comb mode at a first optical frequency is converted up to the double frequency close to a second optical frequency within a laser cavity of the semiconductor laser device, the first optical frequency being about half of the second optical frequency, and wherein a beating signal between the up converted and second optical frequency is generated which can be detected electrically and can be locked to a predetermined beating frequency to stabilize the optical carrier offset frequency.

The second and third order nonlinearities in QCLs can be engineered by bandstructure design. The bandstructure design affects the optical matrix element between two states hence it changes the nonlinear response of the device.

Hence, combining the inherent electrical detector with strong nonlinear second order interactions in the laser cavity, this new apparatus will furthermore allow an all-electrical *f-*to-2*f* stabilization scheme when applied to octave spanning combs. This stabilization technique is not limited to optical frequency combs; any laser output with more than 1 mode generates a beating in the RF-domain, which can be used to stabilize said modes. An example is the stabilization of a dual- or multi-color DFB laser, or any quantum cascade laser device emitting radiation on a multiple of optical frequencies.

Preferably, the predetermined beating frequency is provided by a tunable external reference device, wherein the external reference is controllable such that by changing predetermined beating frequency of the external reference the multi-mode laser output is changed.

It is a further object of the present invention to provide a method for detecting and/or recovering a locked-state of a semiconductor laser device as described herein.
This object is achieved by a method for detecting a locked state of a lasing semiconductor laser device all electrically, in particular a quantum cascade laser device, including the steps of:
- detecting an amplitude noise floor of a bias voltage or of a laser driver current of said semiconductor laser device at predetermined frequencies in a range from 1 Hz up to 100 MHz, preferably up to 10 MHz;
- comparing said amplitude noise to a reference amplitude noise floor derived from the same or a similar reference semiconductor laser device in order to determine whether the semiconductor laser device is in a locked state or an unlocked state.

In a further preferred embodiment of this method, if the comparison of the amplitude noise to the reference amplitude noise floor indicates a loss of the locked state, the locked state is recovered by means of electronics, preferably by means of digital electronics including a computer device and/or a field programmable gate array (FPGA) or by means of analog electronics including a proportional-integral-derivative (PID) system for fast signal recovery of the signal. Those electronics produce an error signal that is adapted to react to the loss of the locked state. The generated signal by one of the previously mentioned methods is then fed back to reset the at least one driver set value.

Having also access to amplitude noise at low frequency through the same means enables intelligent adaptive electronics to recover the locked state of the laser, for example when powering up the laser or when the locking is lost due to mechanical vibrations or other reasons.

In a particularly preferred embodiment, the predetermined beating frequency is provided by an external reference, the external reference being controllable such that by changing predetermined beating frequency of the external reference the multi-mode laser output is changed.

It is yet another object of the present invention to provide a semiconductor laser device with a stabilized multi-mode laser output, which is stabilized internally.
This object is achieved by a semiconductor laser device for producing a multi-mode laser output with an optical carrier offset frequency and at least one optical beating frequency, wherein the at least one optical beating frequency of said laser output is within a bandwidth of a gain-recovery process dominating said semiconductor laser device, said semiconductor laser device including a control unit for driving and/or stabilization said semiconductor laser device, the control unit including at least one driver set value, wherein the semiconductor laser device further includes:
- an electrical detection device adapted for detecting electrically in a bias voltage or in a laser driver current of said semiconductor laser device an electrical beating signal that corresponds to such an optical beating frequency of said laser output; and
- an electronic correction loop adapted to receive said electrical beating signal and to correct said at least one driver set value of the control unit for matching the detected electrical beating signal to a predetermined beating frequency.

Preferably, the semiconductor laser device is adapted to produce as the multi-mode laser output an optical frequency comb, wherein the optical frequency comb preferably comprises a plurality of in a frequency domain equidistantly spaced comb modes or the multi-mode laser output is produced by a multi-color DFB laser.

More preferably, the semiconductor laser device is a deployable device and/or wherein it is or includes a quantum cascade laser.

Preferably, the semiconductor laser device includes two quantum cascade lasers, such that said semiconductor laser device is usable as an all-solid state dual-comb spectrometer device with two optical frequency combs, wherein preferably the two optical frequency combs are preferably fully stabilized with the method as described herein.

Preferably, the semiconductor laser device as described herein (with one or two lasers) further includes at least one external reference, wherein the predetermined beating frequency is provided by said external reference such that changing predetermined beating frequency of the external reference results in a controlled change in the multi-mode laser output.

This laser device, which is locked to a stable external reference by this means, can therefore also be controlled by said reference. Changing the frequency of the external oscillator results in a controlled change in the emitted wavelength of the laser device. This is an easy way of tuning the output frequency of a laser in a controlled and stabilized fashion.

According to the present invention, the feedback parameter may also be the drive current on the laser, wherein the QCL is locked intrinsically by measuring the inter-mode beat and stabilizing this value. According to an aspect of the present invention, the output wavelength is stabilized intrinsically. There is no need for a wavelength scanning unit or external stable light source.

Our method does not directly measure *f*_{ceo}, but we measure *f*ᵣₑₚ and use the coupling between *f*ᵣₑₚ and *f*_{ceo} to stabilize *f*_{ceo}.

The present invention monitors the beating spectrum generated by the interference of the components of the frequency comb source. This information is used to stabilize and control the source, not to reduce the constraints on the source in case of realizing an apparatus (here a time domain FTIR). Furthermore, the monitoring is done on the laser device itself.

It is thus an aspect of the present invention to use for stabilizing of multi-mode laser outputs purposes electrical signals inherently produced during laser light generation, in particular by means of a quantum cascade laser, thereby making obsolete any additional optical feedback mechanism. Such an all-electrical feedback is preferably extracted directly from the bias voltage or the laser drive current of the semiconductor laser; hence, the semiconductor laser acts as its own detector.

The herein described all-electrical stabilization schemes and apparatus are especially useful for field deployable semiconductor combs, since they do not depend on any optical components, but are entirely independent of any optical alignment. Thereby, new avenues for optical frequency comb integrations in products are opened.

A further example is the realization of a time-domain frequency comb spectrometer using such stabilized sources.

It is a further aspect of the present invention to provide a dual-comb spectrometer device comprising at least two of the semiconductor laser devices according to invention, such that said dual-comb spectrometer device is usable as a dual-comb spectrometer with at least two optical frequency combs. Preferably the two optical frequency combs are fully stabilized with the all-electrical stabilization method according to invention.

Preferably, said dual-comb spectrometer device is an all-solid state dual-comb spectrometer device, wherein the at least two semiconductor laser devices and preferably also an absorption cell and a detector are integrated on one and the same single chip device. Thereby, a realization of an all-solid state dual-comb system on a single chip device is provided, wherein said system has the at least two optical frequency-combs producing laser devices and preferably also the absorption cell and the detector integrated in one chip. Such a system-on-a-chip dual-comb spectrometer is particularly useful. Apart from the possibility to realize extremely small high-resolution, fast and high-sensitive spectroscopic systems, the system has the advantage that it is immune to any common noise, making it more robust for field-deployable applications in harsh environmental conditions.

The described stabilization and control technique is not limited to the herein described applications, since any application that relies on stable output wavelength can profit from said stabilization technique.

The all-electrical stabilization schemes and apparatus as presented herein are especially useful for field deployable semiconductor combs, since it does not depend on any optical components. It is entirely independent of any optical alignment and opens new avenues for stable and controlled wavelength output of semiconductor lasers in products. It allows for a tight integrated, field deployable stable and controllable system involving optical semiconductor combs.

### BRIEF DESCRIPTION OF THE DRAWINGS

Preferred embodiments of the invention are described in the following with reference to the drawings, which are for the purpose of illustrating the present preferred embodiments of the invention and not for the purpose of limiting the same. In the drawings,
- Fig. 1: shows a multi-mode output of a semiconductor laser device, more precisely an optical frequency comb. An optical frequency comb is characterized through its equidistance of modes. Each laser mode can therefore be exactly described by a frequency offset *f*_{ceo} and the repetition frequency *f*ᵣₑₚ. The only requirement for a frequency comb output is the equidistance of modes. Therefore the output of such a laser can be AM-like as in fundamentally mode-locked lasers shown in a) or FM-like, shown in b).
- Fig. 2a-c: show schematically preferred embodiments of a stabilization loop of a semiconductor optical frequency comb that does not depend on any optical measurements.
- Fig. 3: shows an amplitude noise spectral density. In a completely locked regime shown in a) the amplitude noise has a different characteristic than in a breakdown region b). In a), the curve for I=460mA collapses with the noise floor (locked state). In b) (unlocked state) the top most curve in the range 1 MHz to 10 MHz is the I=605mA curve, the curve just below that is the I=550mA curve, and the curve just below the latter curve is the I=483mA curve, wherein these three curves are well above the noise floor.
- Fig. 4: shows an inter-mode beat measurement at 7.5 GHz by electrical means only. The signal is extracted through a bias-tee.
- Fig. 5: shows measured correlation between the change of *f*ᵣₑₚ and *f*_{ceo} while changing the bias current of the QCL. The change of the current is in effect a change of the optical cavity length.
- Fig. 6: shows a measured optical inter-mode beat linewidth before (broad Gaussian curve) and after stabilization (sharper multi-peaked curve). The locking loop is realized on the electrical signal read at the output of a bias-tee and is entirely decoupled of the optical signal.

### DESCRIPTION OF PREFERRED EMBODIMENTS

It is an aspect of the present invention to replace the optical detector conventionally used in such laser output stabilization schemes with an inherit detector present in the semiconductor laser device 3 and use this electrical signal as a feedback signal to fully stabilize the multi-mode semiconductor laser output 2. The concept according to invention relates to a stabilization method of a multi-mode laser output 2 requiring no optical detector and relates to an apparatus that uses at least one of semiconductor sources stabilized by means of said stabilization method.

In a particularly preferred embodiment, the semiconductor laser device 3 is a quantum cascade laser (QCL).

Due to the fast gain dynamics in the QCL, any optical beating signals originating from multiple laser oscillations, *i.e.* from the multi-mode laser output 2, are transferred to an electrical beating of the electronic populations. This electrical signal can be used in any semiconductor laser device 3 if the frequency of said signal is within the bandwidth of the gain-recovery processes dominating in said laser device 3. This electrical beating can be measured electrically, preferably through a bias-tee 11 or a directional-coupler, eliminating all optical components.

With such an all-electrical detection scheme it is possible to monitor different frequency ranges. A schematic of a preferred apparatus for monitoring and stabilizing the laser device 3 is shown in **Figure 2a****.** The control unit 4 with at least one driver set value drives the semiconductor laser device 3. The preferred semiconductor driver is a low noise QCL driver, ideally developed for precision chemical measurements. The driver set value can preferably be set through an external voltage. However, it can also be a conventional driver used for semiconductor laser applications. The control unit 4 with at least one driver set value can also drive a temperature control device for stabilization purpose of the semiconductor laser, for example a Peltier element. At least one electrical beating signal *υ*ᵣₑₚ, measured in a bias voltage *V*_{bias} or in a laser driver current *I*ᵢₙₚᵤₜ of said semiconductor laser device 3 and corresponding to an optical beating signal of the multi-mode laser output 2, is extracted and fed back into the system by means of a correction loop 9 including a bias-tee 11, a spectrum analyzer 7a (digital or analog), and a data treatment device 8. The bias-tee 11 is preferably a bias-tee with a large frequency-coverage with a bandwidth of at least *υ*ᵣₑₚ. The bias-tee can also be replaced with a directional coupler or any other suitable device to extract the AC-signal component. The spectrum analyzer can be a conventional analog spectrum analyzer or a digital spectrum analyzer. The spectrum analyzer can be replaced with a fast digital data acquisition board. Depending on the loop implementation, it is enough to record the signal to feed to a proportional-integral-derivative (PID) with an appropriate bandwidth. In case the signal at *υ*ᵣₑₚ is not within the bandwidth of the spectrum-analyzer or the digital data acquisition board, it is possible to mix the signal down to lower frequencies using an RF-mixer or any other means. The data treatment device can be composed of a phase-detector and a PID. The phase detector compares the measured signal from the spectrum-analyzer 7a (or the digital acquisition board) with the stable, low-phase noise external reference. The phase-detector can also be a phase-frequency detector or something similar. This signal, ideally filtered by a loop filter, is then fed to the PID, which generates the correction signal that is fed back to the control unit 4.

The above example is a realization of a phase-locked loop (PLL). Any other implementation of a PLL can also be used. It is also possible to realize a frequency-locked loop to achieve the same goal. This apparatus can also be used if said measured signal at a frequency *υ*ᵣₑₚ has a very large bandwidth or if the signal is composed of multiple *υ*ᵣₑₚ, possibly giving rise to a noise floor at certain frequencies and cannot be used as an input on a PLL. This measured electrical signal in a certain frequency range is preferably used, after additional data treatment, as a correction signal on the driver device 4 or the laser current driver 15 to control and fully stabilize the laser apparatus according to invention. One example of the additional data treatment is the possibility to take the signal from the spectrum analyzer 7a and compare the amplitude, phase, and evolution of certain frequency ranges (*e.g.* kHz compared to MHz) by means of a computer device, if the laser is found in an unlocked state. With the knowledge gained by this data treatment, it is therefore possible to know how to change the input signal on the current driver 15 to recover a lost locked state.

Another preferred embodiment apparatus for monitoring and stabilizing the laser device consists of a control unit 4 for controlling and/or stabilizing the temperature of the semiconductor laser device 3.

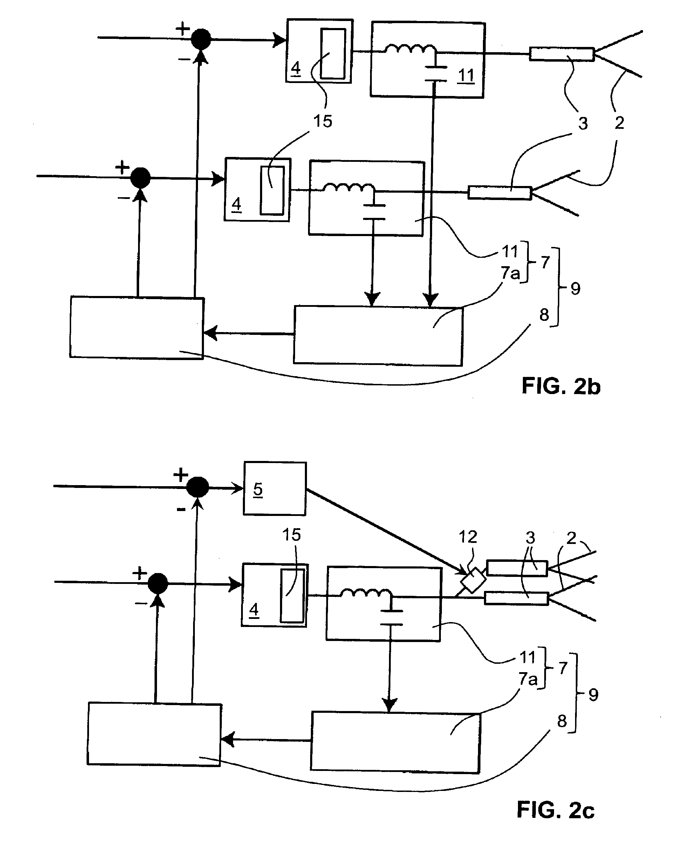

Figures 2b and 2c show further preferred embodiments of the apparatus for monitoring and stabilizing the laser device 3.

In Fig. 2b, the apparatus is the same as the one in Fig. 2a with the difference, that a second laser device 3 is provided, along with a second control unit 4, a second bias-tee 11 or directional coupler or the like, and with a second laser current driver 15. This apparatus may be used as a dual-comb spectrometer device.

In Fig. 2c, the apparatus is the same as the one in Fig. 2b with the difference, that the second laser device 3 uses the same control unit 4 and the same bias-tee 11 or the like as the first laser device 3 uses. The first and second laser devices 3 have the same laser current driver 15 in order to share a common noise in the current, resulting in a common mode noise. In order to drive different and controllable laser currents in the two laser devices 3, a correction device 12 and an additional control unit 5 is provided for. The additional control unit 5 controls the correction device 12. A possibility for the correction device 12 might be a simple adjustable resistor which controls the current division between the two laser devices 3.

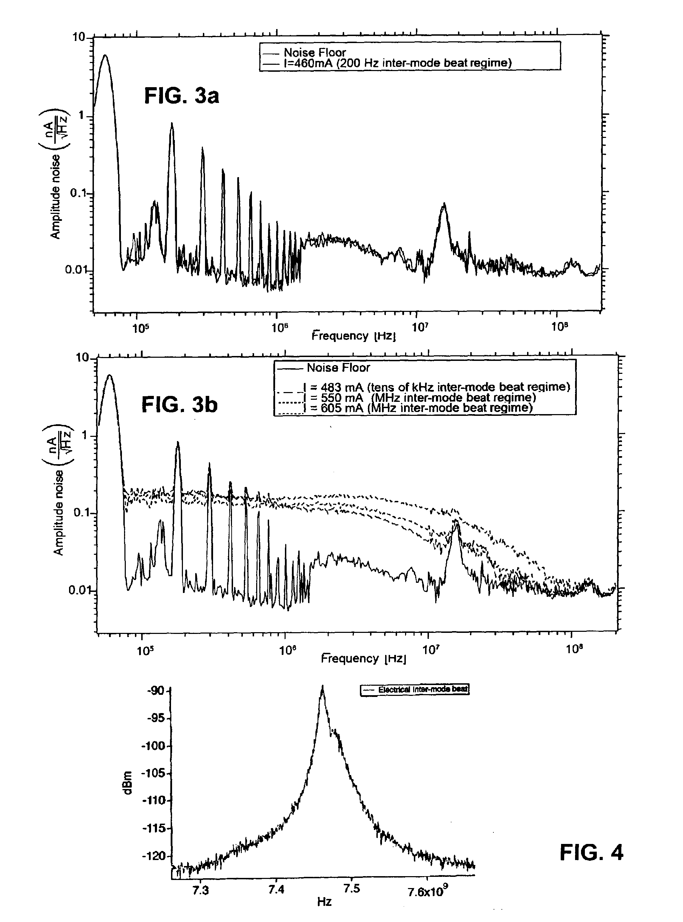

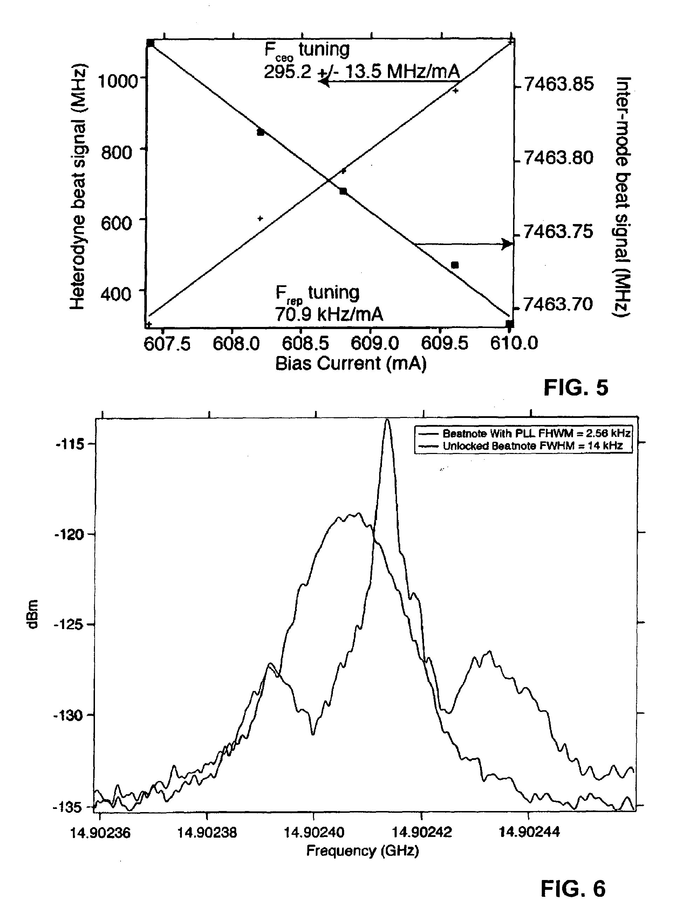

In a yet further aspect of the present invention the inter-mode beat signal is accessed in a higher frequency range if the gain-dynamics of the laser are fast enough, as it is the case in a QCL. The measurement of such an inter-mode beat *υ*ᵣₑₚ through the bias-tee is shown in **Figure 4****.** In any semiconductor laser device 3 featuring an multi-mode output 2 of a comb of equidistant modes in which *f*ᵣₑₚ is locked naturally through ultrafast and non-linear interactions, the measured repetition frequency *f*ᵣₑₚ and *f*_{ceo} are naturally linked. A stabilization of *f*_{ceo} is in effect a stabilization of the resonator cavity length. Since any variation in the cavity length will also lead to a change in the repetition frequency of a passively locked semiconductor laser, any change in the cavity length, and thus in *f*_{ceo}, is also present on the signal *f*ᵣₑₚ. **Figure 5** shows the measured change *f*ᵣₑₚ and a measured change of *f*_{ceo} when the laser injection current *I*ᵢₙₚᵤₜ is changed, where changing this laser driver current *I*ᵢₙₚᵤₜ in the active region changes the effective length of the cavity. Therefore, locking *f*ᵣₑₚ will also lock *f*_{ceo}.

Locking *f*ᵣₑₚ to a certain high-stability microwave local oscillator will result in a reduced locking accuracy by a factor *f*ₒₚₜ/*f*ᵣₑₚ of *f*_{ceo}. In a QCL this is about a factor 5000. The resulting stabilization loop 9 is the same as shown in Fig. 2. A possible additional down mixing of *f*ᵣₑₚ might be necessary to bring it to frequency attainable by feedback loops. A realization of a feedback-loop on *f*ᵣₑₚ is shown in **Figure 6****.** A clear narrowing is observable. The non-stabilized curve is a broad Gaussian curve, while after stabilization a sharper multi-peaked curve is observable. The center-peak is the stabilized signal whereas the two symmetric side-lobes result from the PID feedback and are spaced by the loop bandwidth. Their strength depends on individual PID parameters.

The inter-mode beats of the multi-mode laser output 2 do, however, not necessary need to originate from a comb output 2 of a semiconductor laser 3. Any laser device operating on more than one mode generates such an inter-mode beat. This beating can be stabilized in the same fashion as described herein.

It is a further aspect of the present invention to access the inter-mode beat in a frequency range in the low frequency region (Hz-MHz). This frequency region gives important information on the stability of the multi-mode output 2, *e.g.* the QCL comb operation as it contains low frequency output power noise information. It can be used in conjunction with adaptive electronics to recover the locked state of the laser device 3. **Figure 3** shows the different low frequency amplitude noise behavior if the laser device 3 is in a locked state compared to comb-like emission spectra, in which the locking breaks down. In the locked state, the noise floor and the I=460mA curve collapse (*cf*. Fig. 3a). If the locking is lost (*cf*. Fig. 3(a)), the three broken curves in Fig. 3(a) (top: I =605 mA, middle: 1=550mA, and bottom: I=483mA) are clearly distinguishable from the noise floor (solid line). Hence, by measuring the noise floor and the curve with a predefined current, a comparison between these two (or more) curves reveals, whether the laser device is in a locked or unlocked mode.

Furthermore, it is an aspect of the present invention to provide a locking scenario that is an all-electrical *f*-to-2*f* locking of *f*_{ceo}. The conditions for this locking to work are an octave spanning comb 2 and a semiconductor laser device 3 with second order nonlinearity (as it is the case for QCLs). Through second-harmonic generation, the comb mode at an optical frequency *f* will be up converted to 2f within the laser cavity and can beat with the comb mode at the frequency close to 2f to generate a beating signal to lock *f*_{ceo}. This will give a characteristic-beating signal, which can be used as a locking signal in the scheme shown in Fig. 2. This locking mechanism is especially interesting if one wants to control *f*ᵣₑₚ externally by amplitude or phase modulation, effectively decoupling *f*ᵣₑₚ and *f*_{ceo}. Since the performance of QCL lasers is improving in terms of power and bandwidth, with lasers spanning already dv/v of 40%, this locking scheme could become the standard locking scheme implemented in QCL combs in the future.

The present invention is particularly advantageous for spectroscopy applications. The advantage over optical locking techniques, which rely on optically aligned components and the possibility to apply well-established locking techniques all in the electronic domain, gives this apparatus a clear advantage over previous techniques. For combs that do not span an octave, the possibility to use well-established local oscillators in the microwave domain to control *f*_{ceo} by monitoring *f*ᵣₑₚ has many advantages. Regardless the factor 5000 worse in attainable stability, the proposed scheme can deliver absolute spectral resolutions in the kHz range if *f*ᵣₑₚ is stabilized to Hz linewidths. The proposed all-electrical locking mechanism *f*-to-2*f* improves comb performance, since the stabilization of *f*_{ceo} will not suffer from the reduced accuracy.

**LIST OF REFERENCE SIGNS**

| | | | |
|---|---|---|---|
| 2 | multi-mode laser output | | |
| 3 | semiconductor laser device | *f*_{ceo} | optical carrier offset frequency |
| 4 | control unit | | |
| 5 | additional control unit | *f*ᵣₑₚ | optical beating frequency |
| 7 | electrical detection device | *F*ᵣₑₚ | predetermined beating frequency |
| 7a | Spectrum analyzer | | |
| 8 | Data treatment device | *υ*ᵣₑₚ | electrical beating signal |
| 9 | electronic correction loop | *V*_{bias} | bias voltage |
| 11 | bias-tee | *I*ᵢₙₚᵤₜ | laser driver current |
| 15 | quantum cascade laser driver | | |

## Claims

1. A method for stabilizing and/or controlling an optical frequency of a multi-mode laser output (2) of a semiconductor laser device (3), the multi-mode laser output (2) having an optical carrier offset frequency (*f*_{ceo}) and at least one optical beating frequency (*f*ᵣₑₚ), wherein the at least one optical beating frequency (*f*ᵣₑₚ) of said laser output (2) is within a bandwidth of a gain-recovery process dominating said semiconductor laser device (3), the method including the steps of:
- producing the laser output (2) by means of said semiconductor laser device (3), wherein the semiconductor laser device (3) includes a control unit (4) for driving and/or stabilization purposes, the control unit (4) including at least one driver set value;
- detecting electrically, by means of an electrical detection device (7), in a bias voltage (*V*_{bias}) or in a laser driver current (*I*ᵢₙₚᵤₜ) of said semiconductor laser device (3), at least one electrical beating signal (*υ*ᵣₑₚ) that corresponds to one such optical beating frequency (*f*ᵣₑₚ) of said laser output (2); and
- back-feeding said electrical beating signal (*υ*ᵣₑₚ) into an electronic correction loop (9) and correcting said at least one driver set value of the control unit (4) for matching the detected electrical beating signal (*υ*ᵣₑₚ) to a predetermined beating frequency (*F*ᵣₑₚ).

2. The method according to claim 1, wherein the multi-mode laser output (2) is an optical frequency comb with preferably low group velocity dispersion, preferably comprising a plurality of in a frequency domain equidistantly spaced comb modes.

3. The method according to claim 1 or 2, wherein semiconductor laser device (3) is a quantum cascade laser device, a dual color DFB laser device or a multiple-color DFB laser device, or any quantum cascade laser device emitting radiation on a multiple of optical frequencies.

4. The method according to claim 3, wherein noise information on said bias voltage (*V*_{bias}) or on said laser driver current (*I*ᵢₙₚᵤₜ) in the frequency range from Hz to MHz is determined and compared to a reference in order to determine a locking state of the semiconductor laser device (3).

5. The method according to any one of claims 1 to 4, wherein the electrical detection device (7) includes a bias-tee (11) for extracting the electrical beating signal (*υ*ᵣₑₚ)or wherein the electrical detection device (7) includes a directional coupler for extracting the electrical beating signal (*υ*ᵣₑₚ).

6. The method according to any one of claims 2 to 5, wherein the optical frequency comb is an octave spanning optical frequency comb, wherein the semiconductor laser device (3) has a second order nonlinearity, preferably engineerable as it is the case in a QCL, and wherein, through second-harmonic generation, a comb mode at a first optical frequency is converted up to the double frequency close to a second optical frequency within a laser cavity of the semiconductor laser device (3), the first optical frequency being about half of the second optical frequency, and wherein a beating signal between the up converted and second optical frequency is generated which can be detected electrically (*υ*ᵣₑₚ) and can be locked to a predetermined beating frequency (Fᵣₑₚ) to stabilize said optical carrier offset frequency (f_{ceo}).

7. The method according to any one of claims 1 to 6, wherein the predetermined beating frequency (*F*ᵣₑₚ) is provided by a tunable external reference device, wherein the external reference is controllable such that by changing predetermined beating frequency (*F*ᵣₑₚ) of the external reference the multi-mode laser output (2) is changed.

8. A semiconductor laser device (3) for producing a multi-mode laser output (2) with an optical carrier offset frequency (*f*_{ceo}) and at least one optical beating frequency (*f*ᵣₑₚ), wherein the at least one optical beating frequency (*f*ᵣₑₚ) of said laser output (2) is within a bandwidth of a gain-recovery process dominating said semiconductor laser device (3), said semiconductor laser device (3) including a control unit (4) for driving and/or stabilizing said semiconductor laser device (3), the control unit (4) including at least one driver set value,
**characterized in that** the semiconductor laser device (3) further includes:
- an electrical detection device (7) adapted for detecting electrically in a bias voltage (*V*_{bias}) or in a laser driver current (*I*ᵢₙₚᵤₜ) of said semiconductor laser device (3), at least one electrical beating signal (*υ*ᵣₑₚ) that corresponds to such an optical beating frequency (*f*ᵣₑₚ) of said laser output (2); and
- an electronic correction loop (9) adapted to receive said electrical beating signal (*υ*ᵣₑₚ) and to correct said at least one driver set value of the control unit (4) for matching the detected electrical beating signal (*υ*ᵣₑₚ) to a predetermined beating frequency (*F*ᵣₑₚ).

9. The semiconductor laser device (3) according to claim 8, wherein it is adapted to produce as the multi-mode laser output (2) an optical frequency comb with preferably low group velocity dispersion, wherein the optical frequency comb preferably comprises a plurality of in a frequency domain equidistantly spaced comb modes.

10. The semiconductor laser device (3) according to claim 8 or 9, wherein it is a deployable device and/or wherein it includes a quantum cascade laser or a dual-color DFB laser device or a multiple-color DFB laser device, or any quantum cascade laser device emitting radiation on a multiple of optical frequencies.

11. Dual-comb spectrometer device comprising at least two of the semiconductor laser devices (3) according to any one of claims 8 to 10, such that said dual-comb spectrometer device is usable as a dual-comb spectrometer with at least two optical frequency combs, wherein preferably the two optical frequency combs are preferably fully stabilized with the method according to any one of claims 1 to 7.

12. Dual-comb spectrometer device according to claim 11, wherein the dual-comb spectrometer device is an all-solid state dual-comb spectrometer device, wherein the at least two semiconductor laser devices (3) and preferably also an absorption cell and a detector are integrated on one and the same single chip device.

13. The semiconductor laser device (3) according to any one of claims 8 to 11 further comprising an external reference, wherein the predetermined beating frequency (*F*ᵣₑₚ) is provided by said external reference such that changing predetermined beating frequency (*F*ᵣₑₚ) of the external reference results in a controlled change in the multi-mode laser output (2).

14. A method for detecting a locked state of a lasing semiconductor laser device (3), in particular a quantum cascade laser device (15), including the steps of:
- detecting an amplitude noise floor (17) of a bias voltage (*V*_{bias}) or of a laser driver current (*I*ᵢₙₚᵤₜ) of said semiconductor laser device (3) at predetermined frequencies in a range from 1 Hz up to 100 MHz, preferably up to 10 MHz;
- comparing said amplitude noise (17) to a reference amplitude noise floor (19) derived from the same or a similar reference semiconductor laser device in order to determine whether the semiconductor laser device (3) is in a locked state or an unlocked state.

15. The method according to claim 14, wherein, if the comparison of the amplitude noise (17) to the reference amplitude noise floor (17) indicates a loss of the locked state, the locked state is recovered by means of electronics, preferably by means of:
- digital electronics including a computer device and/or a field programmable gate array, or
- analog electronics realized including a proportional-integral-derivative system for fast signal recovery.
